# EUROPÄISCHE PATENTSCHRIFT

(11) **EP 4 151 782 B1**
(45) Veröffentlichungstag und Bekanntmachung des Hinweises auf die Patenterteilung: **21.02.2024**
(21) Anmeldenummer: 21197148.6
(22) Anmeldetag: 16.09.2021
(51) Int. Cl.: C30B 15/00, C30B 29/06, C30B 33/02, H01L 21/322

(54) **VERFAHREN ZUR HERSTELLUNG EINER HALBLEITERSCHEIBE AUS EINKRISTALLINEM SILIZIUM UND HALBLEITERSCHEIBE AUS EINKRISTALLINEM SILIZIUM**
SINGLE CRYSTAL SILICON SEMICONDUCTOR WAFER AND METHOD OF MANUFACTURING A SINGLE CRYSTAL SILICON SEMICONDUCTOR WAFER
PROCÉDÉ DE FABRICATION D'UNE TRANCHE DE SEMI-CONDUCTEUR À PARTIR DE SILICIUM MONOCRISTALLIN ET TRANCHE DE SEMI-CONDUCTEUR À PARTIR DE SILICIUM MONOCRISTALLIN

(43) Veröffentlichungstag der Anmeldung: 22.03.2023
(73) Patentinhaber: Siltronic AG, 81677 München (DE)
(72) Erfinder: Müller, Timo, 84489 Burghausen (DE); Boy, Michael, 83329 Waging am See (DE); Gehmlich, Michael, 09600 Weißenborn (DE); Kissinger, Gudrun, 15236 Frankfurt (Oder) (DE); Kot, Dawid, 69100 Slubice (PL)
(74) Vertreter: Staudacher, Wolfgang

(56) Entgegenhaltungen:
- EP-A1- 0 962 555
- EP-A1- 3 428 325
- EP-A2- 1 284 311
- WO-A1-2009/028658
- DE-A1-102016 225 138
- US-A1- 2001 055 689
- US-A1- 2010 288 184

## Beschreibung

Gegenstand der Erfindung ist ein Verfahren zur Herstellung einer Halbleiterscheibe aus einkristallinem Silizium sowie eine Halbleiterscheibe aus einkristallinem Silizium.

Die Herstellung bestimmter elektronischer Bauelemente wie beispielsweise solcher vom BCD-Typ (BIPOLAR-CMOS-DMOS) erfordert als Grundmaterial Halbleiterscheiben aus einkristallinem Silizium, die sich durch eine besondere mechanische Robustheit auszeichnen, insbesondere während Bearbeitungsschritten, die über einen längeren Zeitraum bei vergleichsweise hohen Temperaturen durchgeführt werden müssen. Darüber hinaus müssen solche Scheiben üblicherweise erwartete Eigenschaften aufweisen, wie eine denuded zone (DZ) mit einer vorgesehenen Tiefe und einen an die DZ angrenzenden Bereich im Inneren der Halbleiterscheibe mit Keimen, die sich zu BMDs (bulk micro defects) mit einer hohen Spitzen-Dichte entwickeln lassen. Unter einer denuded zone versteht man einen Bereich des Kristallgitters der Halbleiterscheibe, der frei von BMDs ist und in dem sich mittels der Wärmebehandlung keine BMDs erzeugen lassen.

### Stand der Technik / Probleme

Eine RTA-Behandlung unter Argon mit einer Haltetemperatur von mehr als 1300 °C erzeugt eine vergleichsweise flache DZ mit einer Tiefe von wenigen µm, weil Sauerstoff unter solchen Bedingungen in der Nähe der Oberfläche ausdiffundiert. In der US 2012 0 001 301 A1 ist eine solche RTA-Behandlung beschrieben und dass der Verlust von Sauerstoff eine Schwächung der mechanischen Robustheit der Halbleiterscheibe nach sich zieht. Zur Stärkung der mechanischen Robustheit der Halbleiterscheibe und zur Förderung der BMD-Bildung im Inneren kann die Halbleiterscheibe beispielsweise mit Stickstoff dotiert sein. Zur Herstellung der Halbleiterscheibe wird beim Ziehen des Einkristalls nach der Czochralski-Methode (CZ-Methode) darauf geachtet, den Quotienten von Ziehgeschwindigkeit V und axialem Temperaturgradienten G an der Phasengrenze zwischen dem Einkristall und der Schmelze derart zu regeln (V/G-Kontrolle), dass das Kristallgitter bestimmte Eigenschaften in Bezug auf Punktdefekte wie Silizium-Zwischengitteratome (silicon interstitials) und Leerstellen (vacancies) aufweist.

Der Begriff "Rapid Thermal Annealing" (RTA) beschreibt eine Wärmebehandlung, im Zuge derer eine Halbleiterscheibe vergleichsweise schnell auf eine vergleichsweise hohe Temperatur gebracht, vergleichsweise kurz bei dieser Temperatur gehalten wird und anschließend vergleichsweise schnell abgekühlt wird. Eine Vorrichtung, die zum Durchführen einer RTA-Behandlung geeignet ist, ist beispielsweise in US 2003 0 029 859 A1 beschrieben. Die Halbleiterscheibe liegt in der Vorrichtung während der RTA-Behandlung auf einem Ring, wird gedreht und von oben einer Wärmestrahlung ausgesetzt.

Es ist auch bekannt, dass eine RTA-Behandlung unter einer Atmosphäre von Argon und Ammoniak gefolgt von einer RTA-Behandlung unter Argon eine vergleichsweise tiefe DZ hinterlässt (T. Müller et al., "Near-Surface Defect Control by Vacancy Injecting/Out-Diffusing Rapid thermal Annealing", Phys. Status Solidi A, 2019, 1900325).

DE102016225138 A1 offenbart ein Verfahren zur Herstellung einer Halbleiterscheibe aus einkristallinem Silizium, umfassend: das Züchten eines Einkristalls aus Silizium nach der CZ-Methode; das Abtrennen von mindestens einer Halbleiterscheibe aus einkristallinem Silizium vom Einkristall, wobei die Halbleiterscheibe vollständig aus N-Gebiet besteht, in dem keine Agglomerate von Silizium-Zwischengitteratomen oder Leerstellen mit einem Durchmesser von mehr als 20 nm vorhanden sind, und eine Konzentration an Sauerstoff von nicht weniger als 4,5 × 10¹⁷ Atome/cm3 und nicht mehr als 5,5 × 10¹⁷ Atome/cm3 aufweist; eine erste RTA-Behandlung der Halbleiterscheibe bei einer Temperatur in einem ersten Temperaturbereich von nicht weniger als 1285 °C und nicht mehr als 1295 °C über einen Zeitraum von nicht weniger als 20 s und nicht mehr als 40 s in einer ersten Atmosphäre aus Argon und Sauerstoff ; eine zweite RTA-Behandlung der Halbleiterscheibe bei einer Temperatur in einem zweiten Temperaturbereich von nicht weniger als 1160 °C und nicht mehr als 1185 °C über einen Zeitraum von nicht weniger als 15 s und nicht mehr als 30 s in einer zweiten Atmosphäre aus Argon und Ammoniak; und eine dritte RTA-Behandlung der Halbleiterscheibe bei einer Temperatur in einem dritten Temperaturbereich von nicht weniger als 1150 °C und nicht mehr als 1175 °C über einen Zeitraum von nicht weniger als 20 s und nicht mehr als 40 s in einer dritten Atmosphäre aus Argon.

EP3428325 A1 offenbart eine Halbleiterscheibe aus einkristallinem Silizium mit einer Vorderseite und einer Rückseite, bestehend aus N-Gebiet, umfassend eine Konzentration an interstitiellem Sauerstoff von nicht weniger als 5,15 × 10¹⁷ Atome/cm3 und nicht mehr als 5,75 × 10¹⁷ Atome/cm3.

Das Dotieren der Halbleiterscheibe mit Stickstoff während des Ziehens des Einkristalls hat den Nachteil, dass eine vergleichsweise hohe Konzentration an Stickstoff im Inneren der Halbleiterscheibe die Bildung von OSF-Defekten (oxygen induced stacking faults) fördert.

Es ist daher Aufgabe der Erfindung, eine Halbleiterscheibe aus einkristallinem Silizium zugänglich zu machen, die den Anforderungen bezüglich mechanischer Robustheit genügt, ohne mit OSF-Defekten belastet zu sein. Darüber hinaus soll die Halbleiterscheibe die Fähigkeit aufweisen, BMDs unterhalb einer DZ zu entwickeln mit einer radial homogenen BMD-Dichte. Des Weiteren soll die Halbleiterscheibe unabhängig von ihrer Position im Einkristall diese Eigenschaften besitzen.

Die Aufgabe der Erfindung wird gelöst durch ein Verfahren zur Herstellung einer Halbleiterscheibe aus einkristallinem Silizium, umfassend in dieser Reihenfolge
das Züchten eines Einkristalls aus Silizium nach der CZ-Methode;
das Abtrennen von mindestens einer Halbleiterscheibe aus einkristallinem Silizium vom Einkristall, wobei die Halbleiterscheibe vollständig aus N-Gebiet besteht, in dem keine Agglomerate von Silizium-Zwischengitteratomen oder Leerstellen mit einem Durchmesser von mehr als 20 nm vorhanden sind, und eine Konzentration an Sauerstoff von nicht weniger als 5,3 × 10¹⁷ Atome/cm³ und nicht mehr als 5,9 × 10¹⁷ Atome/cm³ und eine Konzentration an Stickstoff von nicht mehr als 1,0 × 10¹² Atome/cm³ aufweist; eine erste RTA-Behandlung der Halbleiterscheibe bei einer Temperatur in einem ersten Temperaturbereich von nicht weniger als 750 °C und nicht mehr als 1100 °C über einen Zeitraum von nicht weniger als 10 s und nicht mehr als 30 s in einer ersten Atmosphäre aus Argon und Ammoniak im Verhältnis von nicht weniger als 1:2 und nicht mehr als 1:0,75;
eine zweite RTA-Behandlung der Halbleiterscheibe bei einer Temperatur in einem zweiten Temperaturbereich von nicht weniger als 1190 °C und nicht mehr als 1280 °C über einen Zeitraum von nicht weniger als 20 s und nicht mehr als 35 s in einer zweiten Atmosphäre aus Argon; und
eine dritte RTA-Behandlung der Halbleiterscheibe bei einer Temperatur in einem dritten Temperaturbereich von nicht weniger als 1160 °C und nicht mehr als 1180 °C über einen Zeitraum von nicht weniger als 15 s und nicht mehr als 25 s in einer dritten Atmosphäre aus Argon und Ammoniak im Verhältnis von nicht weniger als 8:10 und nicht mehr als 3:2.

Eine RTA-Behandlung im Sinne der Erfindung umfasst das schnelle Erhitzen der Halbleiterscheibe aus einkristallinem Silizium auf eine Zieltemperatur, das Halten der Halbleiterscheibe auf der Zieltemperatur für eine Haltedauer und das schnelle Abkühlen der Halbleiterscheibe von der Zieltemperatur. Die Geschwindigkeit des Temperaturanstiegs beim Erhitzen beträgt vorzugsweise nicht weniger als 15 °C/s, besonders bevorzugt nicht weniger als 25 °C/s, die Geschwindigkeit des Temperaturabfalls beim Abkühlen nicht weniger als 25 °C/s. Vorzugsweise sind die Geschwindigkeit des Temperaturanstiegs und die Geschwindigkeit des Temperaturabfalls bei Temperaturen mit einem Abstand von bis zu 100 °C zur Zieltemperatur geringer, als bei Temperaturen mit größerem Abstand. Die Halbleiterscheibe kann von einer Zieltemperatur zur nächsten abgekühlt beziehungsweise erhitzt werden oder zwischen zwei Zieltemperaturen auf eine Grundtemperatur von nicht mehr als 650 °C zwischenzeitlich abgekühlt werden.

Im Zuge der ersten RTA-Behandlung wird die Halbleiterscheibe von einer Grundtemperatur auf eine Zieltemperatur in einem ersten Temperaturbereich von nicht weniger als 750 °C und nicht mehr als 1100 °C erhitzt und über einen Zeitraum von nicht weniger als 10 s und nicht mehr als 30 s auf der Zieltemperatur in einer ersten Atmosphäre aus Argon (Ar) und Ammoniak (NH₃) im Verhältnis von nicht weniger als 1:2 und nicht mehr als 1:0,75 gehalten. Die erste und die dritte RTA-Behandlung stellen Schritte dar, die die Vorderseite der Halbleiterscheibe und in geringerem Maße die Rückseite der Halbleiterscheibe nitridieren. Tatsächlich ist die Konzentration an Stickstoff, die durch eine nitridierende RTA-Behandlung in den oberflächennahen Bereich der Halbleiterscheibe gelangt, auf der Rückseite ungefähr 50 % geringer als auf der Vorderseite. Die Steigerung der Robustheit der Halbleiterscheibe wird dadurch auf den oberflächennahen Bereich der Vorderseite der Halbleiterscheibe fokussiert.

In Kombination mit der zweiten und gegebenenfalls mit einer vierten RTA-Behandlung wird Stickstoff in den oberflächennahen Bereich der Halbleiterscheibe diffundiert. Auf diese Weise gelangen bis zu 2 × 10¹⁵ Atome/cm³ an Stickstoff in den oberflächennahen Bereich der Halbleiterscheibe und sorgen für eine ausreichende Robustheit des Kristallgitters. Eine durch Stickstoff induzierte Bildung von OSF-Defekten im Inneren der Halbleiterscheibe findet nicht statt, weil dort die dafür notwendige Konzentration an Stickstoff nicht erreicht wird.

Die zweite RTA-Behandlung der Halbleiterscheibe wird bei einer Temperatur in einem zweiten Temperaturbereich von nicht weniger als 1190 °C und nicht mehr als 1280 °C über einen Zeitraum von nicht weniger als 20 s und nicht mehr als 35 s in einer zweiten Atmosphäre aus Argon durchgeführt.

Die dritte RTA-Behandlung der Halbleiterscheibe wird bei einer Temperatur in einem dritten Temperaturbereich von nicht weniger als 1160 °C und nicht mehr als 1180 °C über einen Zeitraum von nicht weniger als 15 s und nicht mehr als 25 s in einer dritten Atmosphäre aus Argon und Ammoniak im Verhältnis von nicht weniger als 8:10 und nicht mehr als 3:2 durchgeführt.

Gemäß einer bevorzugten Ausgestaltung der Erfindung wird darüber hinaus noch eine vierte RTA-Behandlung der Halbleiterscheibe bei einer Temperatur in einem vierten Temperaturbereich von nicht weniger als 1130 °C und nicht mehr als 1145 °C über einen Zeitraum von nicht weniger als 25 s und nicht mehr als 35 s in einer vierten Atmosphäre aus Argon durchgeführt.

Um die gestellte Aufgabe zu erfüllen, wird die Halbleiterscheibe von einem Einkristall geschnitten, der nach der CZ-Methode unter V/G-Kontrolle derart gezogen wurde, dass das Kristallgitter der Halbleiterscheibe ausschließlich aus N-Gebiet besteht, in dem keine Agglomerate von Silizium-Zwischengitteratomen oder Leerstellen mit einem Durchmesser von mehr als 20 nm vorhanden sind. Vorzugsweise umfasst das N-Gebiet mindestens eine Ni-Domäne, in der Silizium-Zwischengitteratome als Punktdefektart dominieren und mindestens eine Nv-Domäne, in der Leerstellen als Punktdefektart dominieren. Der Einkristall ist nicht absichtlich mit Stickstoff dotiert. Die Konzentration an Stickstoff beträgt deshalb nicht mehr als 1,0 × 10¹² Atome/cm3. Die vom Einkristall abgetrennte Halbleiterscheibe hat eine Konzentration an Sauerstoff von nicht weniger als 5,3 × 10¹⁷ Atome/cm³ und nicht mehr als 5,9 × 10¹⁷ Atome/cm³ (new ASTM). Die Konzentration an Sauerstoff im Einkristall kann während dessen Herstellung eingestellt werden, beispielsweise über die Regelung der Drehgeschwindigkeit des Tiegels und/oder des Einkristalls und/oder über die Regelung des Drucks und/oder der Durchflussgeschwindigkeit des Gases, das die Atmosphäre bildet, in der der Einkristall wächst, und/oder über die Regelung der Magnetfeldstärke des Magnetfelds, mit dem die Schmelze beaufschlagt wird.

Während des Ziehens des Einkristalls wird die Schmelze vorzugsweise mit einem Magnetfeld beaufschlagt, besonders bevorzugt mit einem horizontalen Magnetfeld oder mit einem CUSP-Magnetfeld.

Die Ziehgeschwindigkeit V beträgt vorzugsweise nicht weniger als 0,5 mm/min, sofern die Herstellung von Halbleiterscheiben mit einem Durchmesser von mindestens 300 mm beabsichtigt ist.

Der Einkristall wächst vorzugsweise in einer Atmosphäre aus Argon oder, besonders bevorzugt, in einer Atmosphäre, die Argon und Wasserstoff enthält. Der Partialdruck an Wasserstoff ist vorzugsweise kleiner als 40 Pa.

Die Weiterverarbeitung der Halbleiterscheibe nach dem Abtrennen vom Einkristall und vor den RTA-Behandlungen umfasst vorzugsweise die mechanische Bearbeitung der vom Einkristall abgetrennten Halbleiterscheibe durch Läppen und/oder Schleifen, das Entfernen oberflächennaher beschädigter Kristallbereiche durch Ätzen und eine Vorreinigung der Halbleiterscheibe in SC1-Lösung, SC2-Lösung und Ozon.

Die Aufgabe der Erfindung wird des Weiteren gelöst durch eine Halbleiterscheibe aus einkristallinem Silizium mit einer Vorderseite und einer Rückseite, bestehend aus N-Gebiet, umfassend
eine Konzentration an interstitiellem Sauerstoff von nicht weniger als 5,3 × 10¹⁷ Atome/cm³ und nicht mehr als 5,9 × 10¹⁷ Atome/cm³;
eine Konzentration an Stickstoff, die von der Vorderseite und von der Rückseite ins Innere der Halbleiterscheibe abnimmt und in einer Tiefe von 50 µm von der Vorderseite nicht weniger als 2,0 × 10¹⁵ Atome/cm³ beträgt.

Vorzugsweise zeichnet sich die Halbleiterscheibe durch folgende weitere Eigenschaften aus:
Die Konzentration an Stickstoff ist, betrachtet in einem oberflächennahen Bereich von der Rückseite bis zu 150 µm ins Innere der Halbleiterscheibe geringer als betrachtet in einem oberflächennahen Bereich von der Vorderseite bis zu 150 µm ins Innere der Halbleiterscheibe. Bis zu einer Tiefe von 150 µm beträgt die Konzentration an Stickstoff im oberflächennahen Bereich der Vorderseite 1,0 × 10¹⁴ Atome/cm³ bis 2,0 × 10¹⁵ Atome/cm³, gemessen mit LT-FTIR. Im Inneren dazwischen sinkt die Konzentration auf ein lokales Minimum, das der Konzentration an Stickstoff im Einkristall entspricht, von dem die Halbleiterscheibe stammt. Die Vorderseite ist diejenige Seite der Halbleiterscheibe, die während der RTA-Behandlung oben liegt. Die Konzentration an Stickstoff im oberflächennahen Bereich der Rückseite der Halbleiterscheibe beträgt annähernd 50 % der Konzentration an Stickstoff im oberflächennahen Bereich der Vorderseite der Halbleiterscheibe.

Die Dichte an Agglomeraten von Leerstellen in der Halbleiterscheibe mit einer Größe von weniger als 20 nm beträgt vorzugsweise weniger als 5,0 × 10¹⁵ cm⁻³, gemessen mit IR-LST und einer Laserleistung von mindestens 70 mW.

Nach einem Test mittels einer Wärmebehandlung der Halbleiterscheibe, mit der Keime zu BMDs entwickelt werden, hat die Halbleiterscheibe eine denuded zone, die sich von der Vorderseite bis zu einer Tiefe von vorzugsweise nicht weniger als 10 µm und nicht mehr als 20 µm ins Innere der Halbleiterscheibe erstreckt. Die Dichte an BMDs beträgt vorzugsweise 4,0 × 10⁹ cm⁻³ bis 8,0 × 10⁹ cm⁻³, besonders bevorzugt 5,0 × 10⁹ cm⁻³ bis 7,0 × 10⁹ cm⁻³. Diese Wärmebehandlung umfasst das Erhitzen der Halbleiterscheibe aus einkristallinem Silizium auf eine Temperatur von 800 °C über eine Dauer von vier Stunden und anschließend das Erhitzen der Halbleiterscheibe auf eine Temperatur von 1000 °C über eine Dauer von 16 Stunden in einer Atmosphäre, die aus zehn Volumen-Anteilen Stickstoff und einem Volumen-Anteil Sauerstoff besteht. Die Dichte an BMDs variiert in radialer Richtung vom Zentrum bis zum Rand der Halbleiterscheibe vorzugsweise um weniger als 15 %. Die Variation wird bestimmt, indem die BMD-Dichte vom Zentrum bis zum Rand an 148 Positionen ermittelt wird und die größte (max) beziehungsweise kleinste (min) ermittelte BMD-Dichte in der Formel (max-min) × 100% / Mittelwert in Beziehung gesetzt werden. Der Mittelwert ist das arithmetische Mittel der an den Positionen ermittelten BMD-Dichten.

Die Eigenschaft der Halbleiterscheibe, BMDs entwickeln zu können, ist unabhängig von der axialen Position vorhanden, die das Material der Halbleiterscheibe im Einkristall hatte, bevor die Halbleiterscheibe davon abgetrennt wurde. Weil der Einkristall nicht absichtlich mit Stickstoff dotiert wird, gibt es keine durch Stickstoff-Segregation hervorgerufenen Effekte, die eine Abhängigkeit dieser Eigenschaft von der axialen Position bewirken.

Nach einem Test mittels einer Wärmebehandlung der Halbleiterscheibe bei Temperatur von 1000 °C über eine Dauer von vier Stunden in trockenem Sauerstoff ist die Dichte an OSF-Defekten vorzugsweise kleiner als 1/cm².

Die Erfindung wird nachfolgend an Beispielen und unter Bezugnahme auf Abbildungen weiter erläutert.
Fig.1 zeigt eine Teilansicht der Anordnung einer Halbleiterscheibe während einer RTA-Behandlung in einer dafür ausgestalteten Vorrichtung.
Fig.2 zeigt den Verlauf der Tiefe der denuded zone in Abhängigkeit des Radius r einer erfindungsgemäßen Halbleiterscheibe.
Fig.3 zeigt den Verlauf der Dichte an BMDs in Abhängigkeit des Radius r einer erfindungsgemäßen Halbleiterscheibe.
Fig.4 zeigt die Anordnung einer Hableiterscheibe während des Erzeugens von thermischem Stress.
Fig.5 zeigt Karten von SIRD-Spannungen in einem ringförmigen Randbereich von Halbleiterscheiben.
Fig.6 zeigt in einem Diagramm den Zusammenhang von Depolarisation und vorhandener Dichte an BMDs.

Liste der verwendeten Bezugszahlen:
- 1: Halbleiterscheibe
- 2: Boden
- 3: Ring
- 4: Zylinder
- 5: Reflektorplatte
- 6: Abdeckung
- 7: obere Lampenbänke
- 8: untere Lampenbänke

In einer Atmosphäre aus Argon und Wasserstoff (Partialdruck von Wasserstoff: 25 - 35 Pa) wurde ein Einkristall aus Silizium gemäß der CZ-Methode gezogen und zu Halbleiterscheiben mit polierter Vorder- und Rückseite weiterverarbeitet. Wegen der beim Ziehen gewählten Bedingungen bezüglich des Quotienten V/G bestand das Kristallgitter der Halbleiterscheiben mit einem Durchmesser von 300 mm ausschließlich aus N-Gebiet, mit einem Anteil an Nv-Domäne und einem Anteil an Ni-Domäne. Die Halbleiterscheiben, die anschließend einer Reihe von RTA-Behandlungen unterzogen wurden, hatten gemäß new ASTM eine Konzentration an Sauerstoff von 5,8 × 10¹⁷ Atome/cm³.

Die Halbleiterscheiben wurden in vier Gruppen geteilt und RTA-Behandlungen unterzogen, deren Bedingungen in der Tabelle zusammengefasst sind:

| | Atmosphäre | Temperatur | Dauer | Gruppe |
|---|---|---|---|---|
| erste RTA-Behandlung | Ar/NH₃ | 1050 °C | 20 s | A, B, C, D |
| | 10:13,5 | | | |
| zweite RTA-Behandlung | Ar | 1270 °C | 30 s | A, B, D C |
| | | 1230 °C | | |
| dritte RTA-Behandlung | Ar/NH₃ | 1170 °C | 20 s | A, C, D B |
| | 5:10 | 1175 °C | | |
| vierte RTA-Behandlung | Ar | 1140 °C | 30 s | C, D |

Die Halbleiterscheiben wurden mit einer Geschwindigkeit von 70 °C/s auf die Zieltemperatur der ersten RTA-Behandlung erhitzt und mit einer Geschwindigkeit von 30 °C/s von der Zieltemperatur der letzten RTA-Behandlung abgekühlt.

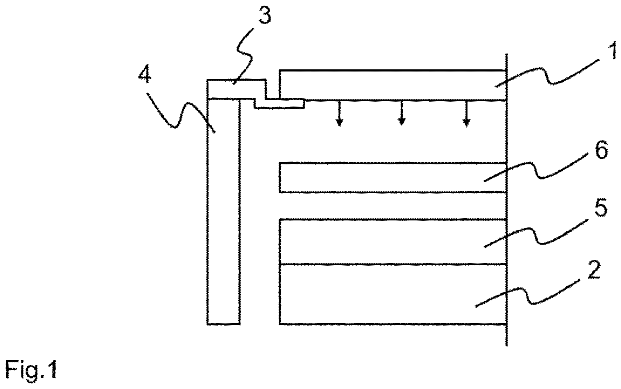

Fig.1 zeigt eine Teilansicht der Anordnung der jeweiligen Halbleiterscheibe 1 während einer RTA-Behandlung in einer dafür ausgestalteten Vorrichtung mit einem Boden 2. Die Halbleiterscheibe 1 liegt auf einem Ring 3 und wird von oben erhitzt, wobei nur die Vorderseite der Halbleiterscheibe 1 direkt der Atmosphäre ausgesetzt ist, welche die RTA-Behandlung vorsieht. Der Ring 3 liegt auf einem Zylinder 4 auf, der gedreht wird. Zwischen der Halbleiterscheibe 1 und einer Reflektorplatte 5 ist eine Abdeckung 6 aus Quarz angeordnet. Die Gegenwart der Abdeckung 6 und der Umstand, dass Gas der Atmosphäre nicht ungehindert zur Rückseite der Halbleiterscheibe gelangen kann, sind maßgeblich verantwortlich dafür, dass die Konzentration an Stickstoff, die im Zuge einer nitridierenden RTA-Behandlung oberflächennah in die Halbleiterscheibe gelangt, im Bereich der Vorderseite der Halbleiterscheibe höher ist, als im Bereich von deren Rückseite.

Zur Bestimmung der Fähigkeit, BMDs in einem inneren Bereich zu entwickeln (BMD-Test), wurden die Halbleiterscheiben in einer Atmosphäre aus einer Mischung von Sauerstoff und Stickstoff mit einem Volumen-Verhältnis von O₂:N₂ von 1:10 zunächst über einen Zeitraum von 4 Stunden bei einer Temperatur von 800 °C und anschließend über einen Zeitraum von 16 Stunden bei einer Temperatur von 1000 °C wärmebehandelt.

Zur Bestimmung der Tiefe der denuded zone, der radialen Dichte-Verteilung und radialen Größen-Verteilung von BMDs stand ein Analyse-Werkzeug vom Typ LST-300A des Herstellers Semilab Co. Ltd., Ungarn zur Verfügung. Damit wurden die Halbleiterscheiben mittels IR-LST (infrared light scattering tomography) untersucht.

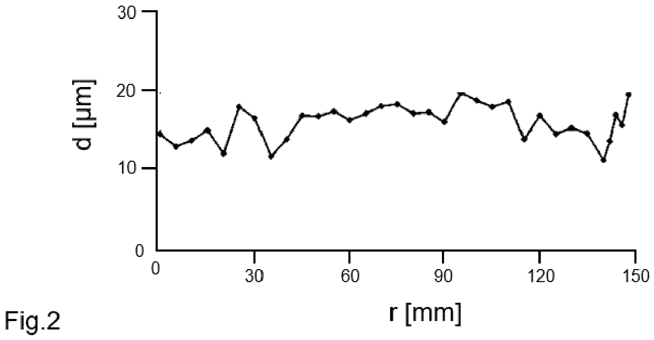

Fig.2 zeigt an einem repräsentativen Beispiel den Verlauf der Tiefe d der denuded zone in Abhängigkeit des Radius r einer erfindungsgemäßen Halbleiterscheibe. Die durchschnittliche Tiefe der denuded zone beträgt etwa 14 µm.

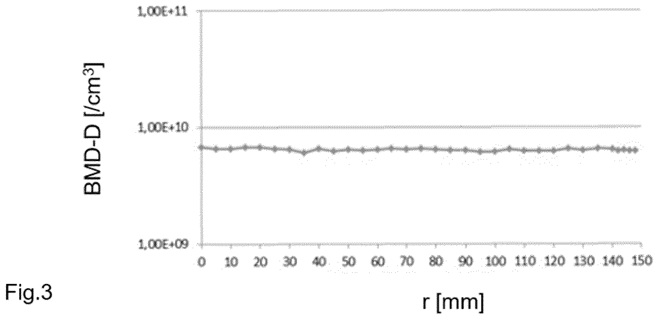

Fig.3 zeigt an einem repräsentativen Beispiel den Verlauf der Dichte an BMDs (BMD-D) in Abhängigkeit des Radius r einer erfindungsgemäßen Halbleiterscheibe. Die durchschnittliche Dichte an BMDs beträgt etwa 6,5 × 10⁹ /cm³. Die radiale BMD Dichten Schwankung beträgt hierbei 11,6 %

Die Halbleiterscheiben wurden thermischem Stress in einem Abscheidereaktor zum Abscheiden einer epitaktischen Schicht unterworfen, um deren Robustheit zu testen. In einem solchen Abscheidereaktor liegt die Halbleiterscheibe zwischen oberen und unteren Lampenbänken, die Wärmestrahlung auf die Rückseite und die Vorderseite der Halbleiterscheibe richten. Der Test war derart konzipiert, dass die Halbleiterscheibe in einem Randbereich um 5 °C stärker erhitzt wurde, als im von Randbereich umschlossenen Zentrumsbereich. Anschließend wurden die Halbleiterscheiben mittels SIRD (Scanning Infra-Red Depolarization) untersucht. Durch die Halbleiterscheibe gestrahlte Infrarot-Strahlung wird in Bereichen des Kristallgitters depolarisiert, in denen thermische Spannungen das Kristallgitter beschädigt haben. Je stärker die Schädigung, desto höher ist die in Depolarisations-Einheiten (DU) gemessene Depolarisierung.

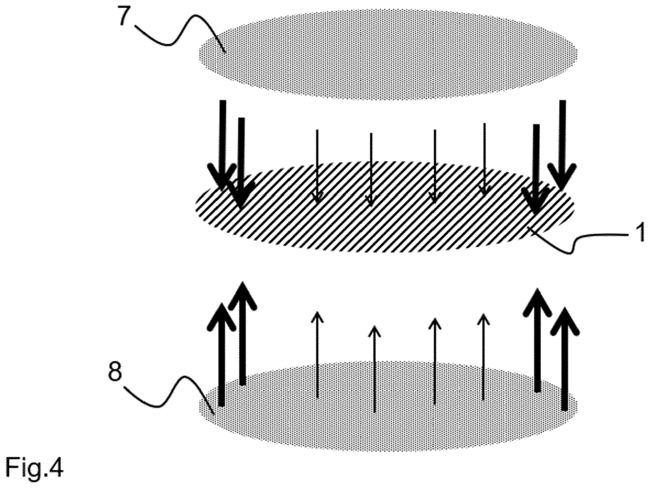

Fig.4 zeigt die Anordnung der Hableiterscheibe 1 während des Erzeugens von thermischem Stress zwischen oberen Lampenbänken 7 und unteren Lampenbänken 8 eines Abscheidereaktors, wobei fett hervorgehobene Pfeile die höhere Temperatur im Randbereich der Halbleiterscheibe symbolisieren, die mittels der Bestrahlung dort erzeugt wird.

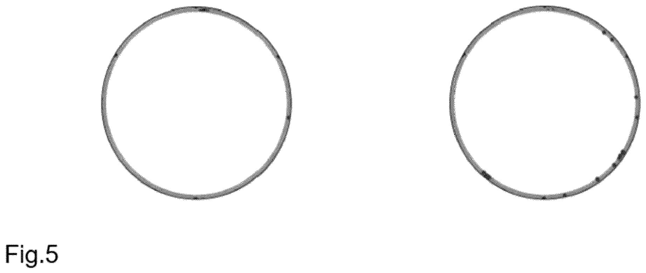

Fig.5 zeigt Karten von SIRD-Spannungen in einem ringförmigen Randbereich (vom Rand bis zu 5 mm radial einwärts) an einem Beispiel (linke Abbildung) und einem Vergleichsbeispiel (rechte Abbildung). Die Halbleiterscheibe gemäß Beispiel gehörte zur Gruppe C, die Halbleiterscheibe gemäß Vergleichsbeispiel unterschied sich davon dadurch, dass sie keinen RTA-Behandlungen unterzogen worden war.

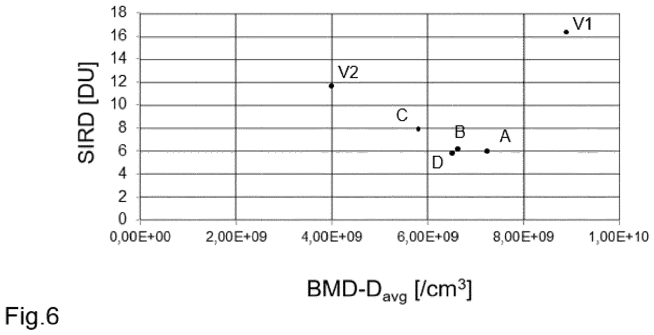

Auf der Halbleiterscheibe gemäß Beispiel wurde bei 0,1 % der untersuchten Fläche eine Schwelle des Betrags der Depolarisierung von 40 DU überschritten, bei der Halbleiterscheibe gemäß Vergleichsbeispiel betrug der Anteil 1,2 %. Fig.6 zeigt in einem Diagramm den Zusammenhang von Depolarisation und vorhandener Dichte an BMDs. Dargestellt ist die mittlere Depolarisation SIRD, bestimmt an über die gesamte Fläche der jeweiligen Halbleiterscheibe verteilten Messpunkten, in Abhängigkeit der mittleren BMD-Dichte BMD-D_{avg}.

Demnach ist die Stressbelastung in Halbleiterscheiben der Gruppen A bis D vergleichsweise klein. Bei den Vergleichsbeispielen von Halbleiterscheiben mit BMD-Dichten von weniger als 4,0 × 10⁹ cm⁻³ oder mehr als 8,0 × 10⁹ cm⁻³ ist die Stressbelastung deutlich größer. Bei den Vergleichsbeispielen handelt es sich um Halbleiterscheiben, die keiner RTA-Behandlung unterzogen worden waren (Vergleichsbeispiel V1) oder solche, bei denen die RTA-Behandlungen teilweise abweichend von der Erfindung durchgeführt wurden (Vergleichsbeispiel V2). So wurde eine erste RTA-Behandlung bei einer Temperatur von 1175 °C über einen Zeitraum von 5 s in einer Atmosphäre aus Argon vorgenommen, gefolgt von einer zweiten RTA-Behandlung bei einer Temperatur von 1170 °C über einen Zeitraum von 15 s in einer Atmosphäre aus Argon und Ammoniak im Verhältnis von 10:7,5 und einer dritten RTA-Behandlung bei einer Temperatur von 1150 °C über einen Zeitraum von 30 s in einer Atmosphäre aus Argon.

## Patentansprüche

1. Verfahren zur Herstellung einer Halbleiterscheibe aus einkristallinem Silizium, umfassend in dieser Reihenfolge
das Züchten eines Einkristalls aus Silizium nach der CZ-Methode;
das Abtrennen von mindestens einer Halbleiterscheibe aus einkristallinem Silizium vom Einkristall, wobei die Halbleiterscheibe vollständig aus N-Gebiet besteht, in dem keine Agglomerate von Silizium-Zwischengitteratomen oder Leerstellen mit einem Durchmesser von mehr als 20 nm vorhanden sind, und eine Konzentration an Sauerstoff von nicht weniger als 5,3 × 10¹⁷ Atome/cm³ und nicht mehr als 5,9 × 10¹⁷ Atome/cm³ und eine Konzentration an Stickstoff von nicht mehr als 1,0 × 10¹² Atome/cm³ aufweist; eine erste RTA-Behandlung der Halbleiterscheibe bei einer Temperatur in einem ersten Temperaturbereich von nicht weniger als 750 °C und nicht mehr als 1100 °C über einen Zeitraum von nicht weniger als 10 s und nicht mehr als 30 s in einer ersten Atmosphäre aus Argon und Ammoniak im Verhältnis von nicht weniger als 1:2 und nicht mehr als 1:0,75;
eine zweite RTA-Behandlung der Halbleiterscheibe bei einer Temperatur in einem zweiten Temperaturbereich von nicht weniger als 1190 °C und nicht mehr als 1280 °C über einen Zeitraum von nicht weniger als 20 s und nicht mehr als 35 s in einer zweiten Atmosphäre aus Argon; und
eine dritte RTA-Behandlung der Halbleiterscheibe bei einer Temperatur in einem dritten Temperaturbereich von nicht weniger als 1160 °C und nicht mehr als 1180 °C über einen Zeitraum von nicht weniger als 15 s und nicht mehr als 25 s in einer dritten Atmosphäre aus Argon und Ammoniak im Verhältnis von nicht weniger als 8:10 und nicht mehr als 3:2.

2. Verfahren nach Anspruch 1, **gekennzeichnet durch** eine vierte RTA-Behandlung der Halbleiterscheibe bei einer Temperatur in einem vierten Temperaturbereich von nicht weniger als 1130 °C und nicht mehr als 1145 °C über einen Zeitraum von nicht weniger als 25 s und nicht mehr als 35 s in einer vierten Atmosphäre aus Argon.

3. Halbleiterscheibe aus einkristallinem Silizium mit einer Vorderseite und einer Rückseite, bestehend aus N-Gebiet, umfassend
eine Konzentration an interstitiellem Sauerstoff von nicht weniger als 5,3 × 10¹⁷ Atome/cm³ und nicht mehr als 5,9 × 10¹⁷ Atome/cm³;
eine Konzentration an Stickstoff, die von der Vorderseite und von der Rückseite ins Innere der Halbleiterscheibe abnimmt und in einer Tiefe von 50 µm von der Vorderseite nicht weniger als 2,0 × 10¹⁵ Atome/cm³ beträgt.

4. Halbleiterscheibe nach Anspruch 3, **dadurch gekennzeichnet, dass** die Stickstoffkonzentration in einem oberflächennahen Bereich der Rückseite niedriger ist, als in einem oberflächennahen Bereich der Vorderseite.

5. Halbleiterscheibe nach Anspruch 3 oder Anspruch 4, **gekennzeichnet durch** eine denuded zone, die sich von der Vorderseite bis zu einer Tiefe von nicht weniger als 10 µm und nicht mehr als 20 µm ins Innere der Halbleiterscheibe erstreckt und einen darunter liegenden Bereich mit BMDs einer Dichte von 5,0 × 10⁹ cm⁻³ bis 7,0 × 10⁹ cm⁻³.

## Claims

1. Method for producing a semiconductor wafer of monocrystalline silicon, comprising in this order
the growing of a single crystal of silicon by the CZ method;
the dividing of at least one semiconductor wafer of monocrystalline silicon from the single crystal, where the semiconductor wafer consists completely of N region, in which there are no agglomerates of silicon interstitials or vacancies having a diameter of more than 20 nm, and has an oxygen concentration of not less than 5.3 × 10¹⁷ atoms/cm³ and not more than 5.9 × 10¹⁷ atoms/cm³ and a nitrogen concentration of not more than 1.0 × 10¹² atoms/cm³;
a first RTA treatment of the semiconductor wafer at a temperature in a first temperature range of not less than 750°C and not more than 1100°C over a period of not less than 10 s and not more than 30 s in a first atmosphere of argon and ammonia in a ratio of not less than 1:2 and not more than 1:0.75;
a second RTA treatment of the semiconductor wafer at a temperature in a second temperature range of not less than 1190°C and not more than 1280°C over a period of not less than 20 s and not more than 35 s in a second atmosphere of argon; and
a third RTA treatment of the semiconductor wafer at a temperature in a third temperature range of not less than 1160°C and not more than 1180°C over a period of not less than 15 s and not more than 25 s in a third atmosphere of argon and ammonia in a ratio of not less than 8:10 and not more than 3:2.

2. Method according to Claim 1, **characterized by** a fourth RTA treatment of the semiconductor wafer at a temperature in a fourth temperature range of not less than 1130°C and not more than 1145°C over a period of not less than 25 s and not more than 35 s in a fourth atmosphere of argon.

3. Semiconductor wafer of monocrystalline silicon having a front side and a back side, consisting of N region, comprising
an interstitial oxygen concentration of not less than 5.3 x 10¹⁷ atoms/cm³ and not more than 5.9 x 10¹⁷ atoms/cm³;
a nitrogen concentration which decreases from the front side and from the back side into the interior of the semiconductor wafer and in a depth of 50 µm from the front side is not less than 2.0 × 10¹⁵ atoms/cm³.

4. Semiconductor wafer according to Claim 3, **characterized in that** the nitrogen concentration in a near-surface region of the back side is lower than in a near-surface region of the front side.

5. Semiconductor wafer according to Claim 3 or Claim 4, **characterized by**
a denuded zone which extends from the front side to a depth of not less than 10 µm and not more than 20 µm into the interior of the semiconductor wafer, and
an underlying region with BMDs of a density of 5.0 × 10⁹ cm⁻³ to 7.0 × 10⁹ cm⁻³.

## Revendications

1. Procédé pour la fabrication d'une tranche semi-conductrice en silicium monocristallin, comprenant, dans cet ordre
le fait de faire croître un monocristal de silicium selon la méthode de CZ ;
la séparation d'au moins une tranche semi-conductrice en silicium monocristallin du monocristal, la tranche semi-conductrice étant constituée complètement par un domaine N, dans lequel on ne trouve aucun agglomérat d'atomes interstitiels de silicium ou de vides présentant un diamètre supérieur à 20 nm et présentant une concentration en oxygène qui n'est pas inférieure à 5,3 x 10¹⁷ atomes/cm³ et pas supérieure à 5,9 x 10¹⁷ atomes/cm³ et une concentration en azote qui n'est pas supérieure à 1,0 × 10¹² atomes/cm³ ; un premier traitement de RTA (rapid thermal annealing - recuit thermique rapide) de la tranche semi-conductrice à une température dans une première plage de température qui n'est pas inférieure à 750°C et pas supérieure à 1100°C pendant une période de temps qui n'est pas inférieure à 10 s et pas supérieure à 30 s dans une première atmosphère d'argon et d'ammoniac dans un rapport qui n'est pas inférieur à 1:2 et pas supérieur à 1:0,75 ; un deuxième traitement de RTA de la tranche semi-conductrice à une température dans une deuxième plage de température qui n'est pas inférieure à 1190°C et pas supérieure à 1280°C sur une période de temps qui n'est pas inférieure à 20 s et pas supérieure à 35 s dans une deuxième atmosphère d'argon ; et
un troisième traitement de RTA de la tranche semi-conductrice à une température dans une troisième plage de température qui n'est pas inférieure à 1160°C et pas supérieure à 1180°C sur une période de temps qui n'est pas inférieure à 15 s et pas supérieure à 25 s dans une troisième atmosphère d'argon et d'ammoniac dans un rapport qui n'est pas inférieur à 8:10 et pas supérieur à 3:2.

2. Procédé selon la revendication 1, **caractérisé par** un quatrième traitement de RTA de la tranche semi-conductrice à une température dans une quatrième plage de température qui n'est pas inférieure à 1130°C et pas supérieure à 1145°C sur une période de temps qui n'est pas inférieure à 25 s et pas supérieure à 35 s dans une quatrième atmosphère d'argon.

3. Tranche semi-conductrice en silicium monocristallin présentant une face avant une face arrière, constituée par un domaine N, comprenant
- une concentration en oxygène interstitiel qui n'est pas inférieure à 5,3 × 10¹⁷ atomes/cm³ et pas supérieure à 5,9 × 10¹⁷ atomes/cm³ ;
- une concentration en azote qui diminue à partir de la face avant et à partir de la face arrière vers l'intérieur de la tranche semi-conductrice et qui n'est pas inférieure à 2,0 × 10¹⁵ atomes/cm³ à une profondeur de 50 µm à partir de la face avant.

4. Tranche semi-conductrice selon la revendication 3, **caractérisée en ce que** la concentration en azote dans une zone proche de la surface de la face arrière est inférieure à celle dans une zone proche de la surface de la face avant.

5. Tranche semi-conductrice selon la revendication 3 ou la revendications 4, **caractérisée par** une zone dénudée qui s'étend à partir de la face avant jusqu'à une profondeur qui n'est pas inférieure à 10 µm et pas supérieure à 20 µm vers l'intérieur de la tranche semi-conductrice et une zone sous celle-ci présentant des BMD (bulk micro defects - gros micro-défauts) d'une densité de 5,0 × 10⁹ cm⁻³ à 7,0 × 10⁹ cm⁻³.
